# FASCICULE DE BREVET EUROPEEN

(11) **EP 1 309 088 B1**
(45) Date de publication et mention de la délivrance du brevet: **17.12.2008**
(21) Numéro de dépôt: 02079271.9
(22) Date de dépôt: 16.10.2002
(51) Int. Cl.: H03K 17/62

(54) **Dispositif de commutation muni de moyens d'inversion de polarité**
Mit Polaritätsumschaltungsmitteln ausgestattete Schaltvorrichtung
Switching device equipped with polarity inversion means

(30) Priorité: 25.10.2001 FR 0113827
(43) Date de publication de la demande: 07.05.2003
(73) Titulaire: NXP B.V., 5656 AG Eindhoven (NL)
(72) Inventeur: Guiraud, Lionel, 75008 Paris (FR); Leclerc, Patrick, 75008 Paris (FR)
(74) Mandataire: Röggla, Harald

(56) Documents cités:
- EP-A- 0 162 994
- EP-A- 0 265 029
- US-A- 5 200 751

## Description

L'invention concerne un dispositif de commutation comportant une pluralité de connexions d'entrée / sortie polarisées pour transmettre des paires de signaux différentiels polarisés entre au moins un émetteur et un récepteur, des connexions d'entrée /sortie étant susceptibles de présenter une inversion de polarisation de sorte que la polarité du signal différentiel transmis est inversée par rapport à la polarité de ladite connexion.

Elle concerne aussi un autocommutateur d'un système de transmissions par liaisons optiques pour réaliser des points de croisement d'une matrice de commutation.

L'invention a de nombreuses applications notamment dans les systèmes de transmissions par liaisons optiques. Elle est particulièrement avantageuse dans les applications de commutation de paquets à haut débits.

Dans les applications utilisant des circuits intégrés, il est souvent difficile de concilier le respect de la polarité des signaux différentiels transmis entre les différents circuits intégrés avec les contraintes de routage du circuit imprimé sur lequel ces circuits sont intégrés. Ces contraintes recommandent notamment d'éviter de croiser des fils sur le circuit imprimé. Pour satisfaire à cette recommandation, les fabricants de circuit intégrés dérogent souvent au respect des contraintes de polarisation. C'est-à-dire que les connexions entre les circuits peuvent ne pas respecter la polarité des signaux transmis. Le non-respect de la polarisations des circuits peut engendrer des erreurs de transmission. C'est pourquoi il est nécessaire de compenser de manière adéquate les défauts de polarisation dans les circuits de façon à corriger les éventuelles erreurs de transmission.

Le document de spécification technique du circuit TZA3019, conçu par la société Philips Semiconductors, décrit un dispositif de commutation du genre mentionné dans le paragraphe introductif. Ce dispositif comporte des moyens d'inversion de polarité en sortie d'une matrice de commutation pour inverser la polarité des signaux différentiels délivrés en sortie selon la configuration de la matrice. En fonction de l'application concernée, la configuration de la matrice est susceptible de varier au cours du temps. Pour s'adapter à ces variations en respectant la polarité des signaux transmis, les moyens d'inversion doivent être reprogrammés au cours de l'application en fonction des variations de configuration de la matrice. La re-programmation des moyens d'inversion de polarité au cours de l'application prend du temps, ce qui est particulièrement désavantageux, notamment dans les applications à haut débit et les applications de type commutation de paquets où la configuration de la matrice varie fréquemment.

La publication EP0 265 029 par Tektronix Inc. divulgue un multiplexeur pour signaux différentiels comportant une pluralité de canaux, chaque canal ayant une paire d'amplificateurs différentiels constituant un étage d'entrée pour recevoir un signal d'entrée différentiel et une paire de transistors pour constituer un étage de sortie pour fournir un signal de sortie différentiel. Il est également décrit une pluralité de sources de courant pour contrôler le multiplexeur. En activant d'une manière sélective les sources de courant, les signaux d'entrée constituant le signal d'entrée différentiel peuvent être appliqués avec une polarité normale ou avec une polarité inversée à un transistor respectif de l'étage de sortie pour produire un signal de sortie différentiel normal ou inversé ou aux deux transistors à la fois de l'étage de sortie pour ne pas produire un signal de sortie différentiel.

Un objet de l'invention est de fournir un dispositif de commutation avantageux qui, pour une application donnée, ne nécessite pas de re-programmation des moyens d'inversion de polarité en fonction des variations de configuration de la matrice de commutation au cours de l'application.

Pour cela, il est prévu un dispositif tel que mentionné dans la revendication 1.

La description suivante, donnée à titre d'exemple non limitatif pour illustrer comment l'invention peut être réalisée, est faite en regard des dessins ci-annexés, parmi lesquels :
- la figure 1 est un schéma bloc fonctionnel pour illustrer un exemple de représentation d'une paire de signaux différentiels utilisés dans un dispositif selon l'invention,
- la figure 2 est un schéma pour illustrer l'importance du respect de la polarité dans un dispositif selon l'invention utilisant une matrice 2x2, selon deux configurations différentes de la matrice, représentées par les figures 2A et 2B, respectivement,
- la figure 3 est un schéma bloc fonctionnel représentant un exemple de réalisation d'un dispositif selon l'invention dans deux configurations différentes de la matrice de commutation, représentées par les figures 3A et 3B, respectivement.
- la figure 4 est un schéma illustrant un mode de réalisation du dispositif selon l'invention,
- la figure 5 est un schéma montrant un exemple de réalisation d'un moyen d'inversion de polarité utilisé dans le dispositif de la figure 4.

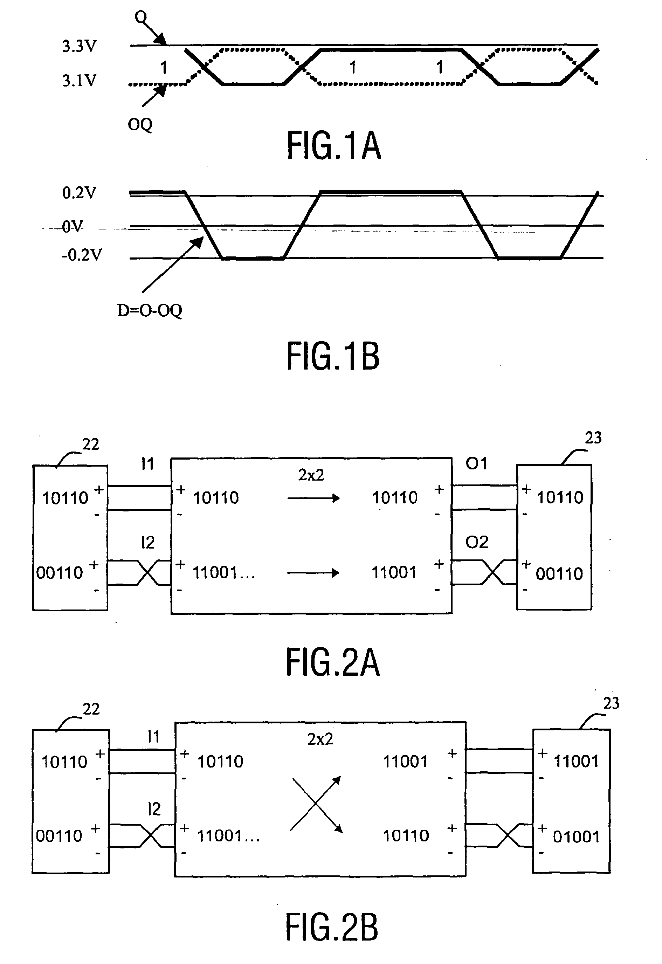

Dans des applications utilisant des circuits intégrés fonctionnant à haut débit, telles que les transmissions optiques, les signaux transmis sont de type différentiels. Ils sont représentés sur la figure 1A par une paire de signaux complémentaires, appelés composantes O et OQ du signal différentiel, noté D. Les deux composantes O et OQ du signal différentiel D sont véhiculées sur deux fils simultanément. Chaque composante du signal peut par exemple être assimilée à une suite de données numériques binaires de type "0" ou "1". La figure 1A illustre un exemple utilisant un codage binaire de type NRZ (Non Retour à Zero). Dans cet exemple, pour la composante O, les tensions 3.3 V et 3.1 V représentent les valeurs "1" et "0", respectivement, et pour la composante OQ, c'est l'inverse. La figure 1B représente le signal différentiel résultant D = O-OQ oscillant entre les tensions différentielles 0.2 V et -0.2 V qui représentent respectivement les valeurs "1" et "0". Une connexion entre 2 blocs échangeant des signaux différentiels doit respecter des règles de polarité pour éviter des erreurs de transmission.

La figure 2 montre l'importance du respect de la polarité dans un exemple d'application utilisant une matrice de commutation 2x2 à deux entrées I1 et I2 et deux sorties O1 et O2 pour relier un émetteur 22 et un récepteur 23. Pour respecter les contraintes de routage des signaux véhiculés dans ce type d'applications, dits signaux RF, les contraintes de polarité ne sont pas toujours respectées comme le montrent les figures 2A et 2B au niveau des connexions I2 et O2. Il s'agit là d'exemples purement arbitraires pour illustrer plusieurs situations possibles. Les croisements de fils au niveau des connexions I2 et O2 représentent une inversion de polarité. Cette inversion de polarité peut être réalisée avec ou sans croisements physiques au niveau de la connexion. Les croisements sur la figure sont une représentation de l'inversion de polarité. La figure 2 illustre le cas particulier d'une matrice 2x2 pour montrer l'importance de la polarisation dans la transmission des messages entre un émetteur et un récepteur via une matrice de commutation. Une matrice 2x2 est utilisée comme exemple pour des raisons de concision. Mais le même raisonnement est applicable à tout type de matrice. Dans l'exemple illustré à la figure 2, il existe 2 configurations possibles pour la matrice de commutation. La figure 2A représente une première configuration dans laquelle l'entrée I1 et envoyée sur la sortie O1 et l'entrée I2 est envoyée sur la sortie O2. La figure 2B représente une deuxième configuration possible dans laquelle l'entrée I1 est envoyée sur la sortie O2 et l'entrée I2 est envoyée sur la sortie O1. Dans chaque configuration, les mêmes messages sont envoyés par l'émetteur 22, aux entrées I1 et I2, respectivement. Selon la configuration étudiée, des messages différents peuvent être reçus par le récepteur sur les sorties O1 et O2, du fait des erreurs de transmission introduites par les inversions de polarité.

Dans la figure 2A, le message "10110" est envoyé de l'entrée I1 sur la sortie O1. Il n'y a pas d'inversion de polarité sur le trajet du message. Le message reçu "10110" est correct puisqu'il est identique au message envoyé. Toujours dans la figure 2A, le message "00110" est envoyé de l'entrée I2 vers la sortie O2. Il y a deux inversions de polarité successives sur le trajet du message. Le message reçu est toujours correct du fait de la compensation réalisée par les deux inversions successives .

Dans la configuration illustrée à la figure 2B, les erreurs de polarité ne sont plus compensées et le message reçu est erroné. En effet, l'entrée I1 est dirigée sur la sortie O2, ce qui introduit une seule inversion de polarité sur le trajet du message. Il en est de même pour l'entrée I2 dirigée sur la sortie O1. Les messages reçus par le récepteur sont donc les compléments binaires des messages émis. La lecture des messages reçus est donc erronée.

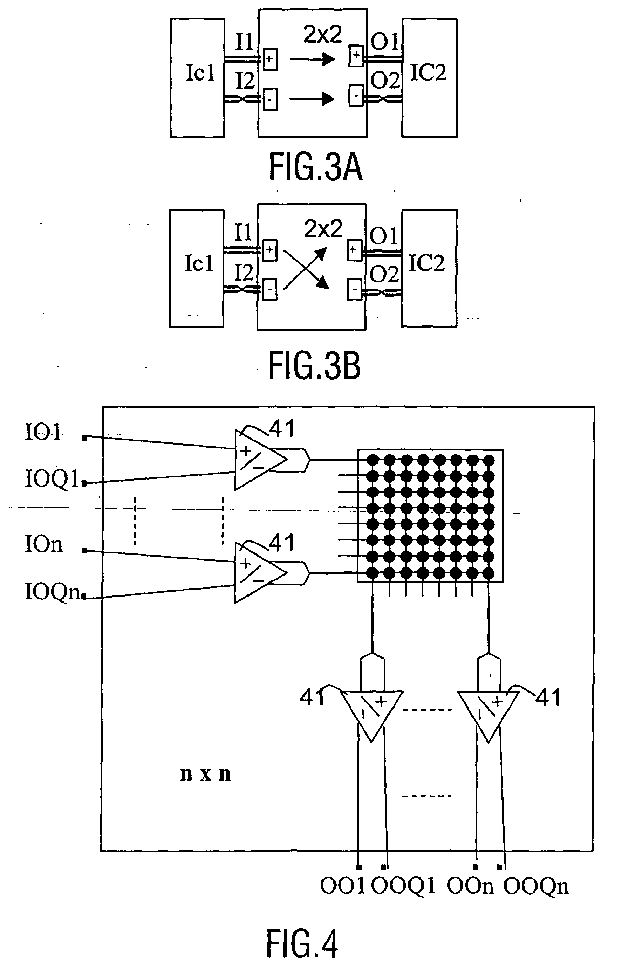

La figure 3 montre un exemple de réalisation d'un dispositif de commutation selon l'invention permettant de compenser les erreurs de polarisation dans les connexions en entrée ou en sortie de la matrice de commutation, quelle que soit la configuration de la matrice. Pour cela, l'invention prévoit d'ajouter des moyens de compensation de polarité sur les entrées et les sorties qui présentent une inversion de polarité du fait du routage choisi. Ces moyens de compensation réalisent une inversion de la polarisation du signal différentiel en entrée et / ou en sortie de la matrice lorsque la polarité de la connexion a été inversée lors de l'implantation des circuits intégrées sur le circuit imprimé. Les figures 3A et 3B représentent deux exemples d'application du dispositif selon l'invention utilisant une matrice de commutation 2x2 pour relier un circuit émetteur IC1 avec un circuit récepteur IC2, à l'aide des entrées I1, I2 et des sortie O1 et 02. L'exemple représenté à la figure 3A correspond à la configuration illustrée à la figure 2A où les entrée I1 et I2 sont dirigées vers les sorties O1 et O2, respectivement. La figure 3B représente un autre exemple correspondant à la configuration illustrée à la figure 2B dans lequel les entrées I1 et I2 sont dirigées vers les sorties croisées O2 et O1, respectivement. Des circuits de compensation de polarité, représentés par des carrés muni d'un signe positif ou négatif, sont présents en entrée et en sortie de la matrice de commutation. Les circuits de compensation sont polarisés pour réaliser une inversion au niveau des entrées et sorties qui présentent une inversion de polarité, représentée par des fils croisés, c'est-à-dire sur les figures 2A et 2B, l'entrée I2 et la sortie O2.

Selon une variante de réalisation de l'invention particulièrement avantageuse, les inverseurs sont commandés par des moyens de contrôle, non représentés, pour permettre de modifier la polarisation de chaque connexion en fonction de l'application concernée, c'est-à-dire du routage des connexions. Une fois la programmation des inverseurs prédéterminée pour une application donnée, la polarisation ne varie plus au cours du temps pendant le déroulement de l'application, quelle que soit la configuration de la matrice qui, elle, peut varier au cours du temps.

La figure 4 montre un exemple de réalisation d'un dispositif selon l'invention utilisant une matrice de commutation n x n comportant n entrées, notées I1 à In, et n sorties, notées O1 à On, chaque entrée et sortie comprenant 2 composantes différentielles indicées O et OQ. Chaque entrée et sortie de la matrice n x n est reliée à un circuit 41 d'inversion de polarité +/- programmé de façon adéquate pour inverser la polarisation des connexions qui présentent une inversion de polarité inhérente à la conception de ces connexions.

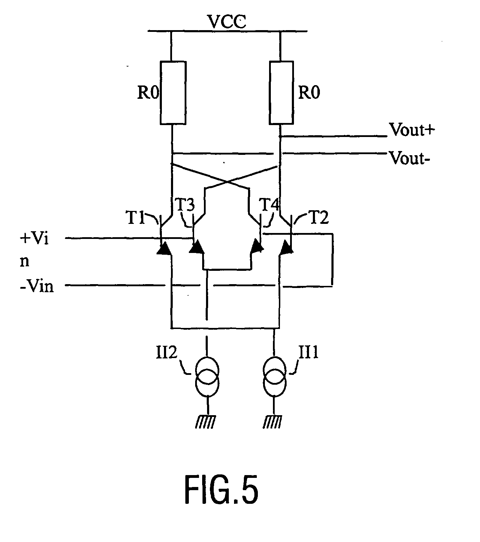

La figure 5 montre un exemple de réalisation du circuit d'inversion de polarité 41 représenté à la figure 4. D'autres circuits peuvent être utilisés. Le schéma de la figure 5 représente un dispositif d'inversion de polarité destiné à recevoir un signal d'entrée Vin, et à délivrer un signal de sortie Vout qui est une image de Vin ou une image inversée de Vin. Ici, Vin représente une des composantes O ou OQ des signaux différentiels véhiculés dans le dispositif de commutation représenté à la figure 4. Le dispositif de commutation de polarité inclut deux paires différentielles, composées des transistors (T1,T2) et (T3,T4), respectivement, dont la conduction est pilotée par le signal d'entrée Vin. Les deux paires différentielles (T1,T2) et (T3,T4) sont polarisées au moyen de sources de courant commutables II1 et II2 destinées à débiter un courant dans la première ou la seconde paire différentielle en fonction de la programmation choisie. Des moyens de contrôle, non représentés sont prévus pour contrôler la commutation des sources de courant en fonction de l'application. Les résistances R0 opèrent une transformation courant - tension de l'information de courant provenant des paires différentielles. Lorsque la source de courant II1 est allumée et que la source de courant II2 est éteinte le signal de sortie Vout est une image du signal d'entrée Vin, et lorsque la source de courant II2 est allumée et que la source de courant II1 est éteinte le signal de sortie Vout est une image inversée du signal d'entrée Vin.

## Revendications

1. Dispositif de commutation comportant :
- une matrice de commutation qui comporte au moins une paire de bornes d'entrée (11, 12) et au moins une paire de bornes sortie (Q1, Q2) ;
- des moyens de connexion d'entrée pour transmettre des signaux différentiels d'un émetteur (22) aux bornes d'entrée de la matrice de commutation ;
- des moyens de connexion de sortie pour transmettre des signaux différentiels des bornes de sortie de la matrice de commutation à un récepteur (23), les moyens de connexion d'entrée / sortie étant polarisés pour transmettre des paires de signaux différentiels polarisés entre au moins un émetteur (22) et un récepteur (23), et les moyens de connexions d'entrée / sortie étant susceptibles de présenter une inversion de polarisation de sorte que la polarité du signal différentiel transmis est inversée par rapport à la polarité de desdites moyens de connexion, le dispositif étant **caractérisé en ce qu'**il comporte :
- des moyens de compensation associés à chaque paire de bornes d'entrée agencés pour inverser la polarité du signal différentiel lorsque les moyens de connexion d'entrée présentent une inversion de polarité du signal différentiel transmis vers la paire de bornes respective; et
- des moyens de compensation associés à chaque paire de bornes de sortie agences pour inverser la polarité du signal différentiel lorsque les moyens de connexion de sortie présentent une inversion de polarité du signal différentiel reçu de la paire de bornes respective.

2. Dispositif selon la revendication 1, dans lequel les moyens de compensation sont programmables et sont adaptés aux moyens de connexions d'entrée / sortie pour inverser la polarité de chaque moyen de connexion d'entrée / sortie qui présente une inversion de polarisation.

3. Dispositif selon la revendication 2, comportant des moyens de contrôle associés aux moyens de compensation programmables pour contrôler la polarisation des moyens de connexions d'entrée / sortie en fonction de la polarité des paires de signaux différentiels transmis par lesdites moyens de connexions.

4. Dispositif selon l'une des revendications 1 à 3, dans lequel les moyens de compensation comprennent deux paires différentielles chaque paire étant connectée à une source de courant commutable.

5. Dispositif selon l'une des revendications 1 à 4, destiné à être incorporé dans un autocommutateur d'un système de transmissions par liaisons optiques pour réaliser des points de croisement d'une matrice de commutation, les paires de signaux différentiels étant des signaux optiques.

6. Autocommutateur d'un système de transmissions par liaisons optiques pour réaliser des points de croisement d'une matrice de commutation, l'autocommutateur comportant un dispositif de commutation selon l'une des revendications 1 à 5.

## Claims

1. A switching device comprising:
- a switching matrix which comprises at least a pair of input terminals (I1, I2) and at least a pair of output terminals (Q1, Q2);
- input connection means for transmitting differential signals from a transmitter (22) to the input terminals of the switching matrix;
- output connection means for transmitting differential signals from the output terminals of the switching matrix to a receiver (23), the input/output connection means being biased for transmitting pairs of biased differential signals between at least one transmitter (22) and one receiver (23) and the input/output connection means being suitable for providing an inversion of the polarity in such a way that the polarity of the transmitted differential signal is inverted with respect to the polarity of said connection means, the device being **characterized in that** it comprises:
- compensation means associated with each pair of input terminals which are arranged for inverting the polarity of the differential signal when the input connection means present a polarity inversion of the differential signal that is transmitted to the respective pair of terminals; and
- compensation means associated with each pair of output terminals which are arranged for inverting the polarity of the differential signal when the output connection means present a polarity inversion of the differential signal that is received from the respective pair of terminals.

2. A device as claimed in claim 1, wherein the compensation means are programmable and are adapted to the input/output connection means for inverting the polarity of each input/output connection means which presents a polarity inversion.

3. A device as claimed in claim 2, comprising control means associated with the programmable compensation means so as to control the polarity of the input/output connection means as a function of the polarity of the pairs of differential signals transmitted through said connection means.

4. A device as claimed in any one of claims 1 to 3, wherein the compensation means comprise two differential pairs, each pair being connected to a switchable current source.

5. A device as claimed in any one of claims 1 to 4, intended to be incorporated n an autoswitch of a transmission system using optical connections so as to realize crossing points of a switching matrix, the pairs of differential signals being optical signals.

6. An autoswitch for a transmission system using optical connections for realizing crossing points for a switching matrix, the autoswitch comprising a switching device as claimed in any one of claims 1 to 5.

## Patentansprüche

1. Schaltvorrichtung, aufweisend:
- eine Schaltmatrix, die mindestens ein Paar Eingangsklemmen (I1, I2) und mindestens ein Paar Ausgangsklemmen (Q1, Q2) aufweist,
- Eingangsverbindungsmittel zur Übertragung der Differentialsignale eines Senders (22) an die Eingangsklemmen der Schaltmatrix,
- Ausgangsverbindungsmittel zur Übertragung der Differentialsignale der Ausgangsklemmen der Schaltmatrix an einen Empfänger (23), wobei die Eingangs-/Ausgangsverbindungsmittel polarisiert sind, um polarisierte Differentialsignalpaare zwischen mindestens einem Sender (22) und einem Empfänger (23) zu übertragen, und wobei die Eingangs-/Ausgangsverbindungsmittel imstande sind, eine Umkehrung der Polarisierung aufzuweisen, so dass die Polarität des übertragenen Differentialsignals im Verhältnis zur Polarität der genannten Verbindungsmittel umgekehrt ist, wobei die Vorrichtung **dadurch gekennzeichnet ist, dass** sie folgendes aufweist:
- mit jedem Eingangsklemmenpaar verbundene Ausgleichsmittel, die ausgebildet sind, um die Polarität des Differentialsignals umzukehren, wenn die Eingangsverbindungsmittel eine Polaritätsumkehrung des auf das jeweilige Klemmenpaar übertragenen Differentialsignals aufweisen, und
- mit jedem Ausgangsklemmenpaar verbundene Ausgleichsmittel, die ausgebildet sind, um die Polarität des Differentialsignals umzukehren, wenn die Ausgangsverbindungsmittel eine Umkehrung der Polarität des Differentialsignals aufweisen, das beim jeweiligen Klemmenpaar eingeht.

2. Vorrichtung nach Anspruch 1, wobei die Ausgleichsmittel programmierbar sind und an die Eingangs-/Ausgangsverbindungsmittel angepasst sind, um die Polarität jedes Eingangs-/Ausgangsverbindungsmittels umzukehren, das eine Umkehrung der Polarisierung aufweist.

3. Vorrichtung nach Anspruch 2, mit den programmierbaren Ausgleichsmitteln verbundene Prüfmittel aufweisend, um die Polarisierung der Eingangs-/Ausgangsverbindungsmittel in Abhängigkeit von der Polarität der Differenzialsignalpaare zu prüfen, die von den Verbindungsmitteln übertragen werden.

4. Vorrichtung nach Anspruch 1 bis 3, wobei die Ausgleichsmittel zwei Differentialpaare aufweisen, wobei jedes Paar mit einer umschaltbaren Stromquelle verbunden ist.

5. Vorrichtung nach einem der Ansprüche 1 bis 4, die zur Integration in einen selbsttätigen Umschalter eines Übertragungssystems durch optische Verbindungen bestimmt ist, um Kreuzungspunkte einer Schaltmatrix auszuführen, wobei die Differentialsignalpaare optische Signale sind.

6. Selbsttätiger Umschalter eines Übertragungssystems durch optische Verbindungen zur Ausführung der Kreuzungspunkte einer Schaltmatrix, wobei der selbsttätige Umschalter eine Schaltvorrichtung nach einem der Ansprüche 1 bis 5 aufweist.
